# EUROPÄISCHE PATENTANMELDUNG

(11) **EP 0 801 150 A2**
(43) Veröffentlichungstag der Anmeldung: **15.10.1997**
(21) Anmeldenummer: 97105395.4
(22) Anmeldetag: 01.04.1997
(51) Int. Cl.: C23C 30/00, G01L 9/06, G01D 5/14, G01K 7/01, G01F 1/684

(54) **Elektronisches Bauelement**

(30) Priorität: 12.04.1996 DE 19614459
(71) Anmelder: GRUNDFOS A/S, DK-8850 Bjerringbro (DK)
(72) Erfinder: Jensen, Niels Due, 8850 Bjerringbro (DK); Brown, Tina Romedahl, Sahl, 8850 Bjerringbro (DK); Dyrbye, Karsten, Mammen, 8850 Bjerringbro (DK); Andersen, Per Ellemose, 8850 Bjerringbro (DK)
(74) Vertreter: Vollmann, Heiko, Dipl.-Ing.

(57) **Zusammenfassung**

Das elektronische Bauelement ist in Dickfilmtechnik, Dünnfilmtechnik oder Siliziumtechnologie hergestellt und dann mit einer elektrisch isolierenden Schicht versehen (7), die von einer amorphen Metallschicht (8) überdeckt wird. Die amorphe Metallschicht (8) schützt das Bauelement schon bei geringster Schichtdicke zuverlässig gegen äußere Einflüsse und leitet Wärme- und Krafteinflüsse unmittelbar weiter.

## Beschreibung

Die Erfindung betrifft ein elektronisches Bauelement, das in Dickfilm-, Dünnfilmtechnik oder Siliziumtechnologie hergestellt ist.

Derartige elektronische Bauelemente werden heutzutage in mannigfaltigsten Ausführungen hergestellt und eingesetzt. Insbesondere dann, wenn ein solches elektronisches Bauelement einen Sensor aufweist oder bildet und zur Erfassung physikalischer Größen vorgesehen ist, stellen sich besondere Probleme hinsichtlich der Kapselung. Einerseits muß das Bauelement möglichst dicht gegenüber dem umgebenden Medium gekapselt sein, insbesondere dann, wenn aggressive Gase oder Flüssigkeiten anstehen, andererseits soll der das Bauelement abdeckende Werkstoff möglichst dünn aufgetragen sein, damit beispielsweise die Temperaturleitung an das Bauelement oder aber auf das Bauelement wirkende Kräfte möglichst direkt und unverfälscht übertragen werden.

Die übliche Einbettung in Kunststoff genügt meist dann, wenn lediglich die Umgebungsluft mit dem Bauelement in Kontakt tritt. Wird jedoch das Bauelement mit beispielsweise Flüssigkeit, wie Wasser, Alkohol, Öl oder dergleichen in Verbindung gebracht, so reicht diese Einbettung in Kunststoffmasse in der Regel nicht aus, da solche Kunststoffe häufig nicht ausreichend dicht gegenüber Flüssigkeiten sind. Die Flüssigkeit kann durch den Kunststoff diffundieren und erreicht so das elektronische Bauelement, das durch diesen unmittelbaren Kontakt geschädigt oder gar zerstört wird. Eine gewisse Verbesserung kann dadurch erzielt werden, daß die einbettende Kunststoffschicht entsprechend dick ausgebildet wird, was jedoch den eingangs erörterten Nachteil beispielsweise mangelnder Wärmeleitfähigkeit bzw. schlechter Kraftübertrag mit sich bringt. Eine zuverlässige Kapselung gegenüber Flüssigkeiten ist meist ohnehin nur durch metallische Kapselung möglich, was durch Eingliederung des Bauelementes in entsprechend geformte Bleche erfolgt. Zwar ist die Wärmeleitung solcher Bleche gut, doch ist eine Ankoppelung des Bauelementes an das Blech erforderlich, zudem ist eine Kraftübertragung auf das Bauelement durch das Blech hindurch praktisch nicht möglich.

Um eine möglichst gute Kraftübertragung auf ein Bauelement der erwähnten Art zu erhalten, ist es beispielsweise aus US-PS 4,686,764 und US-PS 4,732,042 bekannt, das Bauelement, das dort als Membran eines Differenzdrucksensors eingesetzt wird, mit einer verhältnismäßig dicken Gelschicht abzudecken, die einerseits so flexibel ist, daß sie die Kraftübertragung auf die Membran und deren Bewegung kaum behindert, andererseits jedoch so fest ist, daß sie nicht durch Fließvorgänge abhandenkommt. Zwar können auf diese Weise Druckkräfte relativ gut auf die Membran übertragen werden, doch ist die Übertragung von Wärme von der anstehenden Flüssigkeit auf das Bauelement zumindest mit spürbarer zeitlicher Verzögerung gegeben, da sowohl die Konstruktion zum Halten der Gelschicht auf dem Bauelement als auch die Gelschicht selbst einen schnellen Wärmefluß behindern. Eine solche Anordnung ist also zur Erfassung von Temperaturen oder Übertragung von Wärme weniger geeignet.

Hiervon ausgehend liegt der Erfindung die Aufgabe zugrunde, ein Bauelement der eingangs erwähnten Art zu schaffen, das einerseits zuverlässig gegen äußere Einflüsse, insbesondere Umgebungseinflüsse, Wasser und dergleichen geschützt ist, andererseits in möglichst gut wärme- und kraftleitender Verbindung mit dem umgebenden Medium steht.

Diese Aufgabe wird gemäß der Erfindung durch die im kennzeichnenden Teil des Anspruches 1 aufgeführten Merkmale gelöst. Die Erfindung sieht somit vor, das elektronische Bauelement mit einer amorphen Metallschicht zu versehen. Je nach Art und Ausführung des elektronischen Bauelementes ist diese amorphe Metallschicht gegebenenfalls zuvor durch Aufbringen einer elektrisch isolierenden Schicht vom Bauelement elektrisch zu trennen. Da die amorphe Metallschicht - auch unter dem Begriff Metallglas bekannt - aufgrund ihrer amorphen Struktur schon bei Schichtdicken im umBereich vollständig flüssigkeitsdicht ist und andererseits eine hohe Härte aufweist, bietet eine solche Metallschicht einerseits einen guten Schutz für das Bauelement und andererseits bei geeigneter, möglichst dünner Schichtdicke eine nahezu ideale und zeitlich praktisch nicht verzögerte Wärmeleitfähigkeit vom Umgebungsmedium zum Bauelement und auch umgekehrt. Darüberhinaus werden Kräfte, insbesondere Druckkräfte des anstehenden Mediums nahezu verlustfrei und mit höchster Genauigkeit auf das elektronische Bauelement übertragen. Letzteres ist insbesondere dann von Vorteil, wenn das Bauelement als Sensor für Druck oder andere Kräfte ausgebildet ist oder einen solchen aufweist.

Das elektronische Bauelement gemäß der Erfindung bietet zahlreiche Anwendungsmöglichkeiten. So kann es beispielsweise als Druck- und/oder Temperatursensor dienen. Es ist aber auch denkbar, das erfindungsgemäße Bauelement als wärmeerzeugenden Widerstand als Teil eines Meßgerätes zur Erfassung der Fließgeschwindigkeit auszubilden. Hierbei kann sowohl das Heizelement als auch der oder die Temperaturfühler als elektronisches Bauelement gemäß der Erfindung ausgebildet sein. Die hohe Wärmeleitfähigkeit der dünnen Metallschicht ermöglicht eine sehr genaue und schnelle Messung. Wegen der geringen Dicke der Schicht wird einerseits eine gute Wärmeleitfähigkeit quer zur Schicht und eine schlechte Wärmeleitfähigkeit in Längserstreckung zur Schicht bewirkt. Diese ist insbesondere für den Einsatz des Bauelementes als Teil eines Durchflußmeßgerätes von Vorteil.

In analoger Weise kann ein erfindungsgemäßes Bauelement auch dazu vorgesehen sein, daß eine Kühlflüssigkeit oder ein sonstiges Kühlmedium zur Abfuhr der darin entstehenden Abwärme genutzt wird. Auch hier wird die gute Wärmeleitfähigkeit der extrem dünnen Metallschicht von Vorteil sein, wobei das Bauelement selbst durch diese Schicht zuverlässig vor äußeren Einflüssen geschützt wird. Denn die weiter unten näher spezifizierte amorphe Metallschicht ist wesentlich korrosionsfester und verschleißfester als beispielsweise dünne Edelstahlbleche, die in einer Dicke, in der sie flüssigkeitsdicht sind, schon eine solche Eigensteifigkeit aufweisen, daß sie zur Übertragung von Kräften auf das elektronische Bauelement nur sehr bedingt geeignet sind.

Ein weiterer Vorteil des erfindungsgemäßen Bauelementes liegt darin, daß die amorphe Metallschicht selbst leitend ist, so daß sie auch als Abschirmung dienen kann, indem diese Schicht mit Erde oder mit einem beliebig zu wählenden Potential verbunden wird.

Schließlich kann eine solche amorphe Metallschicht kostengünstig insbesondere auch in der Großserienfertigung hergestellt werden. Die Bauelemente können in an sich bekannter Weise zu mehreren nebeneinander angeordneten Bauelementen in Form eines Wafers oder einer Oblate hergestellt werden, dann mit einer elektrisch isolierenden Schicht belegt und schließlich mit einer amorphen Metallschicht bedampft werden. Erst dann erfolgt zweckmäßigerweise die Trennung der einzelnen Bauelemente voneinander.

Die elektrisch isolierende Schicht kann extrem dünn sein, da sie lediglich die Aufgabe hat sicherzustellen, daß die amorphe Metallschicht keinen Kurzschluß des darunter befindlichen elektronischen Bauelementes verursacht. Andererseits ist sie aufgrund der Abdeckung durch die amorphe Metallschicht gut geschützt. Aufgrund dessen, daß sich die Metallschicht nicht in Kristallstruktur, sondern in amorpher Struktur befindet, ist sie zum einen hoch korrosionsfest und zum anderen auch schon bei dünnster Schichtdicke flüssigkeits- und auch gasdicht. Derartige amorphe Metallschichten sind beispielsweise aus EP 0 537 710 A1, DE 42 16 150 A1, DE 38 14 444 A1 bekannt. Es wird in diesem Zusammenhang auch auf folgende Veröffentlichung hingewiesen: Palmström, C. J.; J. Gylai und J. W. Meyer in J. Vac. Sci. Technol. A1C21, April-June 1983, Seiten 452 ff.

Bevorzugt wird das Bauelement insbesondere bei Ausbildung als Membran im wesentlichen aus Silizium bestehen. Die elektrisch isolierende Schicht kann dann aus Siliziumoxid, Siliziumnitrit oder Polyimid bestehen. Die überdeckende amorphe Metallschicht wird bevorzugt auf der Basis von Chrom-Tantal oder Chrom-Titan bestehen, da diese eine hohe Verschleißfestigkeit und über einen weiten Zusammensetzungsbereich gute elastische Eigenschaften besitzen.

Um die Flüssigkeitsdichtheit der amorphen Metallschicht zu gewährleisten, sollte die Schichtdicke mindestens 0,1 µm betragen, dies entspricht etwa 700 Atomschichten. Andererseits sollte die Metallschicht aus den eingangs erläuterten Gründen möglichst dünn sein. Die maximale Schichtdicke sollte daher etwa bei 5 µm liegen. Bevorzugt ist ein Bereich zwischen 0,5 und 1,5 µm, bei dem einerseits eine zuverlässige Dichtheit der amorphen Metallschicht und andererseits eine hohe Beweglichkeit derselben gesichert ist, was insbesondere bei der Übertragung von Kräften von Vorteil ist.

Soll das Bauelement Teil eines Differenzdruckmessers bilden, dann ist es zweckmäßig, wenn die Membran Teil eines plattenförmigen Trägers ist, der das elektronische Bauelement bildet und einstückig mit der Membran ausgebildet ist. Der Membranbereich wird dann dadurch ausgebildet, daß hier der Träger eine geringere Dicke aufweist, so daß sich ein auslenkfähiger Bereich ergibt. Im übrigen kann dann der gesamte Träger mit zunächst der elektrisch isolierenden und dann der Metallglasschicht abgedeckt werden. Dies hat insbesondere auch Vorteile bei der Einspannung des so gebildeten Sensorelementes. Die amorphe Metallschicht bildet dann eine Schutzschicht gegenüber dem Medium, dessen Druck zu erfassen ist. Bei einer solchen Anordnung kann auf die eingangs erwähnte Gelschicht vollständig verzichtet werden. Eine Temperaturkompensation der Messung kann aufgrund der guten Wärmeleitung sehr exakt erfolgen, falls diese aufgrund der direkten Sensorelektronikanordnung nicht ohnehin überflüssig wird.

Die Erfindung ist nachfolgend anhand von in der Zeichnung dargestellten Ausführungsbeispielen näher erläutert. Es zeigen:
- Fig. 1: in schematischer Darstellung einen Längsschnitt durch einen Träger mit darin befindlicher Membran,
- Fig. 2: eine Draufsicht auf einen Träger nach Fig. 1, jedoch ohne abdeckende Schichten,
- Fig. 3: einen Längsschnitt durch die Halterung im Bereich der Einspannstelle in stark vereinfachter Darstellung,
- Fig. 4: eine andere Ausführung der Einspannung in Darstellung nach Fig. 3,
- Fig. 5: einen Teil der Halterung mit Dichtelement und Träger in Explosionsdarstellung und
- Fig. 6: den weiteren Teil der Halterung zu Fig. 5.

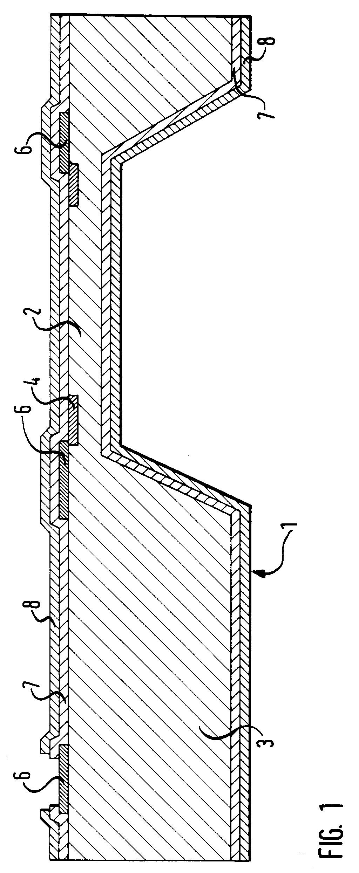

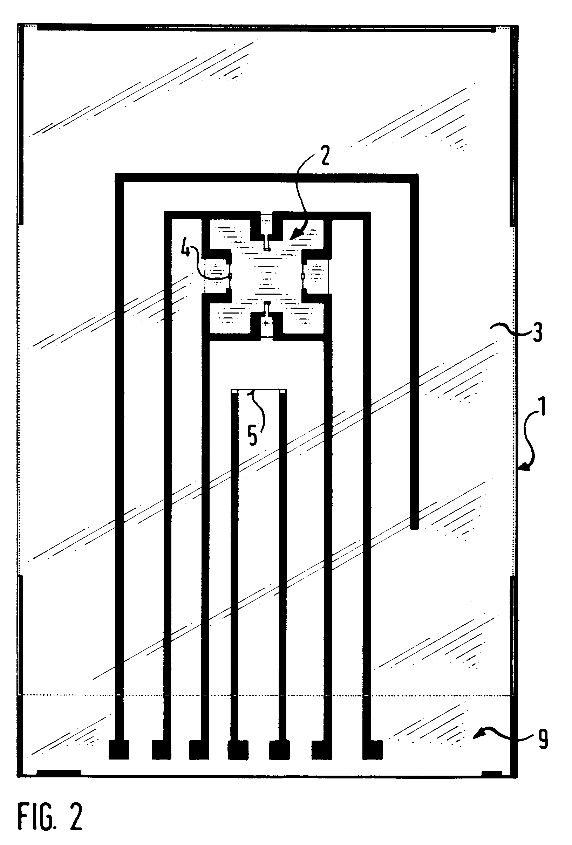

Der anhand der Figuren 1 und 2 dargestellte Träger 1 hat in Draufsicht (Fig. 2) eine etwa rechteckige Form. Er weist in einem mittleren etwa quadratischen Bereich 2 eine deutlich geringere Dicke auf. Deiser Bereich 2 bildet eine Membran eines Druck- oder Differenzdrucksensors, während der übrige Träger im wesentlichen als starr anzusehen ist. Träger 1 und Membran 2 sind aus Silizium gebildet. Im Bereich der Membran sind auf den Siliziumgrundkörper 3 vier Widerstände 4 zur Erfassung der Membranauslenkung sowie unmittelbar benachbart zur Membran 2 ein weiterer Widerstand 5 zur Temperaturkompensation des Sensors aufgebracht. Der elektrische Anschluß der Widerstände 4 und 5 erfolgt über ebenfalls unmittelbar auf dem Träger 1 aufgebrachte Leiterbahnen 6, die aus Aluminium bestehen. Die Leiteranordnung zu den Widerständen 4 ist schon vorbereitend zu einer Brückenschaltung ausgebildet, die Kontaktpunkte zu den Leiterbahnen 6 zur weiteren Verdrahtung liegen sämtlichst an einer Seite des Trägers 1, und zwar entfernt von der Membran 2.

Membran 2 und Träger 1 sind beidseitig von einer Siliziumoxidschicht 7 überdeckt. Diese Schicht 7 ist unmittelbar auf den Siliziumgrundkörper 3 bzw. die Widerstände 4 und 5 sowie die Leiterbahnen 6 aufgebracht. Die Silizumoxidschichten 7 zu beiden Seiten des Trägers 1 sind jeweils von einer Metallglasschicht 8 überdeckt. Diese amorphe Metallschicht ist aufgedampft und weist eine Dicke von etwa 1 µm, das sind etwa 7.000 Atomschichten auf. Die Metallglasschicht 8 ist flüssigkeits- und gasundurchlässig. Sie hat eine gegenüber kristallinen Edelstählen deutlich höhere Korrosionsfestigkeit und Härte. Dennoch beeinträchtigt sie das Meßverhalten der Membran 2 praktisch nicht, da sich diese Schicht nur eleastisch verformt. Sie schützt diese somit in nahezu optimaler Weise vor äußeren Einflüssen. Um einen Kurzschluß der auf dem Siliziumgrundkörper 3 gebildeten Widerstände und Leiterbahnen durch die Metallglasschicht 8 zu verhindern, ist die elektrisch isolierende Siliziumoxidschicht 7 vorgesehen.

Bei dem beschriebenen Ausführungsbeispiel besteht die Metallglasschicht 8 aus einer amorphen Metallegierung auf der Grundlage von Chrom-Tantal bzw. Chrom-Titan. Es wird in diesem Zusammenhang auf EP 0 537 710 A1 verwiesen.

Wie in Fig. 2 dargestellt, ist ein sich parallel zur Schmalseite des Trägers 1 verlaufender Streifen 9 vorgesehen, in dem die Leiterbahnen 6 weder durch eine Siliziumoxidschicht 7 noch durch eine Metallglasschicht 8 abgedeckt sind. Hier laufen die Leiterbahnen 6 zum Zwecke der Kontaktierung (Bonding) aus.

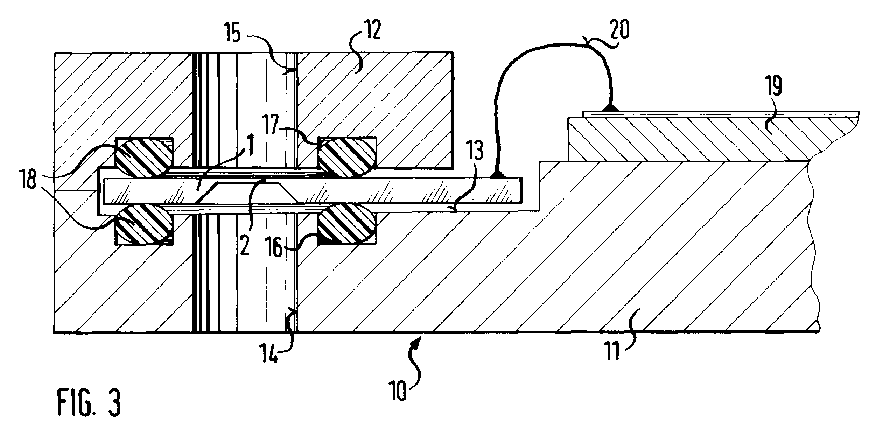

Der vorbeschriebene Träger 1 ist in einer Halterung 10 derart druckdicht eingegliedert, daß die Membran 2 beidseitig fluidbeaufschlagbar ist. Anhand von Fig. 3 ist dies schematisch dargestellt. Die Halterung 10 besteht dort aus einem plattenförmigen Grundkörper 11 und einer Abdeckplatte 12, die miteinander unter Eingliederung des Trägers 1 verbunden sind. Der plattenförmige Grundkörper 11 weist eine flächige Vertiefung 13 auf, etwa in der Größe des Trägers 1, zur Aufnahme desselben. Weiterhin weisen der plattenförmige Grundkörper 11 und die Abdeckplatte 12 zueinander fluchtende Ausnehmungen 14 und 15 auf, durch die die Membran 2 fluidbeaufschlagbar ist. Die Bauteile 11 und 12 weisen jeweils konzentrisch zu ihren Ausnehmungen 14 und 15 Ringnuten 16 und 17 auf, in denen O-Ringe 18 liegen, welche den Träger 1 druckdicht zwischen den Bauteilen 11 und 12 einspannen. Die Anordnung ist so gewählt, daß die Membran 2 innerhalb der Ausnehmungen 14 ud 15 frei zugänglich ist, während der Streifen 9, der zur Kontaktierung der Enden der Leiterbahnen 6 vorgesehen ist, jenseits der Abdichtung innerhalb der Halterung 10 liegt. Im übrigen ist die Halterung so ausgebildet, daß lediglich der Bereich der Ausnehmungen 14 und 15 fluidbeaufschlagbar ist, der übrige Teil jedoch gegenüber dem Fluid abgedichtet ist.

Auf dem Grundkörper 11 ist eine Platine 19 angeordnet, welche weitere elektronische Bauteile zur Aufbereitung des Meßsignales aufweist. Diese Platine 19 ist über Leiter 20 elektrisch mit den Leiterbahnen 6 des Trägers 1 verbunden. Die Kontaktierung erfolgt durch Anlöten oder Anschweißen der Leiter 20 an den durch den Streifen 9 frei zugänglichen Enden der Leiterbahnen 6 (sogenanntes Bonding).

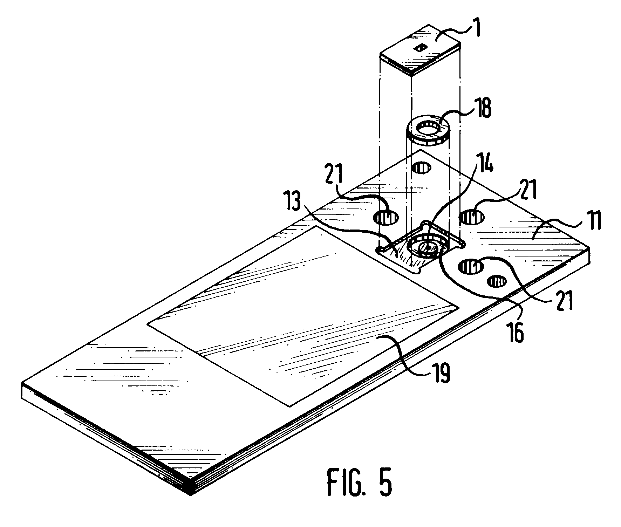

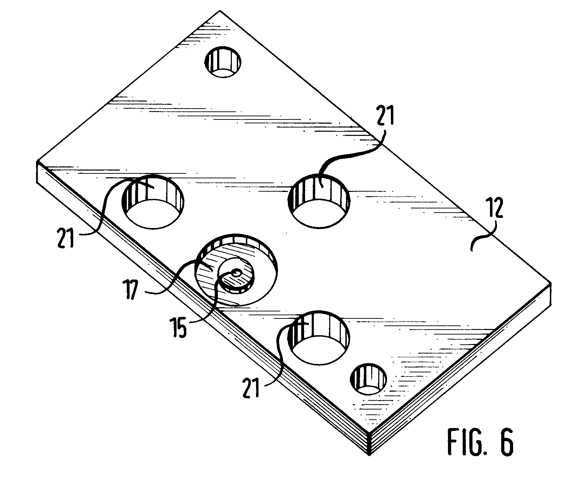

Der weitere elektronische, elektrische und vorrichtungsmäßige Aufbau des Differenzdrucksensors ist in an sich bekannter Weise ausgeführt und wird deshalb hier nicht im einzelnen nicht erörtert. Der Aufbau, soweit es die Halterung 10 angeht, ist anhand der Figuren 5 und 6 näher veranschaulicht. Dort sind zur Verbindung der plattenförmigen Bauteile 11 und 12 neben der Vertiefung 13 angeordnete Bohrungen 21 jeweils fluchtend in Grundkörper 11 und Abdeckplatte 12 vorgesehen, durch die eine Schraub- oder Nietverbindung zwischen den beiden Bauteilen hergestellt werden kann.

Der so gebildete Sensor kann als Drucksensor Verwendung finden, wenn die Membran 2 nur einseitig druckbeaufschlagt wird. Zur Verwendung als Differenzdrucksensor wird die Membran 2 beidseitig fluidbeaufschlagt.

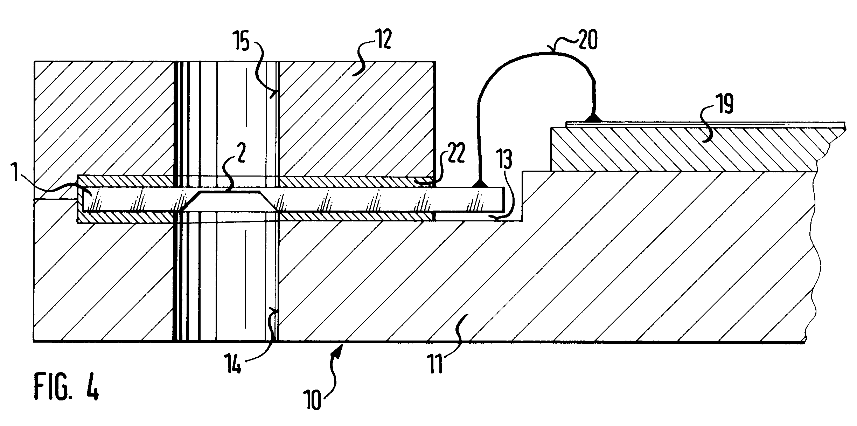

Anhand von Fig. 4 ist eine alternative Einspannung des Trägers 1 zwischen den Bauteilen 11 und 12 dargestellt. Dieses Ausführungsbeispiel unterscheidet sich von dem anhand von Fig. 3 dargestellten dadurch, daß auf die Ringnuten 16, 17 sowie die O-Ringe 18 verzichtet worden ist und statt dessen der Träger 1 mittels einer Klebschicht 22 zwischen dem plattenförmigen Grundkörper 11 und der Abdeckplatte 12 eingegliedert ist. Diese Eingliederung ist insofern von Vorteil, als die auftretenden Spannungen im Träger 1 und in der Membran 2 deutlich geringer als bei der vorbeschriebenen Einspannung sind. Dies ist in Hinblick auf die Meßgenauigkeit und Linearität der Messung von Vorteil. In jedem Fall jedoch erfolgt die Einspannung des Trägers 1 zwischen den Bauteilen 11 und 12 vor Kontaktierung der Enden der Leiterbahnen 6, da der vergleichsweise empfindliche Träger 1 nach dem Eingliedern in die Halterung 10 wesentlich einfacher und sicherer zu handhaben ist als vorher.

### Bezugszeichenliste

- 1: - Träger
- 2: - Membran
- 3: - Siliziumgrundkörper
- 4: - Widerstände
- 5: - Widerstand
- 6: - Leiterbahnen
- 7: - Siliziumoxidschicht
- 8: - Metallglasschicht
- 9: - Streifen
- 10: - Halterung
- 11: - plattenförmiger Grundkörper
- 12: - Abdeckplatte
- 13: - Vertiefung
- 14: - Ausnehmungen
- 15: - Ausnehmung
- 16: - Ringnut
- 17: - Ringnut
- 18: - O-Ringe
- 19: - Platine
- 20: - Leiter
- 21: - Bohrungen
- 22: - Klebstoff

## Patentansprüche

1. Elektronisches Bauelement, das in Dickfilm-, Dünnfilmtechnik oder Siliziumtechnologie hergestellt ist, dadurch gekennzeichnet, daß es ggf. nach Aufbringen einer elektrisch isolierenden Schicht (7) mit einer amorphen Metallschicht (8) versehen ist.

2. Bauelement nach Anspruch 1, dadurch gekennzeichnet, daß es einen Sensor (2) zur Erfassung mindestens einer physikalischen Größe aufweist oder ein solcher ist.

3. Bauelement nach einem der vorhergehenden Ansprüche, dadurch gekennzeichnet, daß das Bauelement die Membran (2) eines Druck- oder Differenzdrucksensor mit darauf befindlichem Meßelement (4) und ggf. weiterer Elektronikteile (5) ist und daß die amorphe Metallschicht (8) eine Schutzschicht gegenüber dem Medium bildet, dessen Druck zu erfassen ist.

4. Bauelement nach einem der vorhergehenden Ansprüche, dadurch gekennzeichnet, daß das Bauelement, insbesondere die Membran (2) im wesentlichen aus Silizium, daß die elektrisch isolierende Schicht (7) aus Siliziumoxid, Siliziumnitrit oder Polyimid und daß die amorphe Metallschicht (8) aus Metallglas, vorzugsweise auf der Basis von Chrom-Tantal oder Chrom-Titan besteht.

5. Bauelement nach einem der vorhergehenden Ansprüche, dadurch gekennzeichnet, daß die Membran (2) Teil einer plattenförmigen Trägers (1) und einstückig mit diesem ausgebildet ist.

6. Bauelement nach einem der vorhergehenden Ansprüche, dadurch gekennzeichnet, daß die amorphe Metallschicht (8) eine Dicke von 0,1 bis 5 µm, vorzugsweise von 0,5 bis 1,5 µm aufweist.

7. Bauelement nach einem der vorhergehenden Ansprüche, dadurch gekennzeichnet, daß es ein Temperatursensor ist.

8. Bauelement nach einem der vorhergehenden Ansprüche, dadurch gekennzeichnet, daß es einen Temperatursensor sowie ein davon beabstandetes Heiz- und/oder Kühlelement aufweist und Teil eines Durchflußmeßgerätes bildet.
